# EUROPEAN PATENT APPLICATION

(11) **EP 0 766 299 A2**
(43) Date of publication of application: **02.04.1997**
(21) Application number: 96307068.5
(22) Date of filing: 27.09.1996
(51) Int. Cl.: H01L 21/66, H01L 23/544

(54) **Improvements in or relating to monitoring systems**

(30) Priority: 29.09.1995 US 4583
(71) Applicant: TEXAS INSTRUMENTS INCORPORATED, Dallas Texas 75265 (US)
(72) Inventor: Bentley, John K., Irving, TX 75038 (US); McKee, Robert E., IV, Plano, TX 75023 (US); Brugler, Mercer L., Flower Mound, TX 75028 (US)
(74) Representative: Legg, Cyrus James Grahame

(57) **Abstract**

The operation of a wet hood (10) may be electronically monitored by positioning various infrared detectors above a first tank (12), a second tank (14), a third tank (16), a fourth tank (18), a fifth tank (20), and a sixth tank (22). A first detection zone (54), a second detection zone (56), a third detection zone (58), a fourth detection zone (60), a fifth detection zone (62), and a sixth detection zone (64) are established above these tanks by their corresponding detectors. Each of these tanks contains a solution so that a carrier or a wafer boat (90) may be manually placed within one of the tanks. When the wafer boat (90) enters the detection zone of one of these tanks, an entry signal is sent to a computer/controller (78) and a timer is started in response. The computer/controller (78) sends a signal to an output device indicating that a tank has entered a particular detection zone. The computer/controller (78) compares the timer value to a predefined process time value. As the timer value approaches this predefined time value, the computer/controller (78) sends a corresponding signal to an output device, such as an operator console (82), to indicate that the operation time period is about to expire. When the wafer boat (90) is manually removed from a tank, the actual time the wafer boat (90) remained in the tank is stored as historical data.

## Description

### TECHNICAL FIELD OF THE INVENTION

The present invention relates generally to the field of monitoring systems, and more particularly to a system and method for electronically monitoring an operation.

### BACKGROUND OF THE INVENTION

As technology continues to advance, more and more manual operations and processes are being performed automatically by machines. However, many of these operations and processes may never be automated because of the corresponding high cost of automation. Many existing structures and installations used in performing manual operations and processes cannot be easily and inexpensively modified and converted so that automated operations may be performed. Yet, many of these existing structures and installations have many more years of useful life.

Non-automated or manual operations are those operations performed through human interaction and activity. As compared to automated operations, manual operations are often less predictable, less uniform, and more error prone. This is due to the fact that humans cannot perform every operation with the same degree of accuracy and precision on every occasion. These problems are amplified when the same manual operations are being performed by different individuals that do not share the same skills, experience, and dedication.

These deficiencies and drawbacks of manual operations can be especially troublesome and costly. For example, it is very difficult to objectively evaluate employee or operator performance when manual operations are being performed. Objective data is not available to fully evaluate an employee's performance over a period of time. Furthermore, when errors do occur in manual operations, it is often difficult to recreate what errors actually occurred so that preventive measures may be taken. In some cases, if an error is known, corrective action may be available to prevent having to discard items improperly processed. Since errors in manual operations are normally not known, corrective action is impossible resulting in costly waste.

Another disadvantage of manual operations is the inability to optimize a particular process or operation. The inaccuracies and imprecision of manual operations makes it difficult to determine if a particular process or operation is being performed in an optimal manner. The absence of actual historical data prevents any type of analysis or optimization to be performed to further refine and perfect a particular process or operation. However, as discussed above, fully automated systems are very expensive and the disadvantages of manual operations may not justify incurring the substantial expense of fully automating these operations.

### SUMMARY OF THE INVENTION

From the foregoing it may be appreciated that a need has arisen for a system and method for electronically monitoring various operations and processes. In accordance with the present invention, a system and method for electronically monitoring an operation is provided which substantially eliminates and reduces disadvantages and problems associated with manual operations which do not provide accurate historical operations data and which do not provide operator assistance to improve and standardize manual operations.

According to an embodiment of the present invention, there is provided a system for electronically monitoring an operation or process that includes an identification device having a unique identification number and a number of electronic detectors for electronically monitoring the movement of the identification device. The system also includes a computer for receiving and storing signals from the detectors and for sending signal to an output device to alert an operator as to the status of a particular operation or process. The output device may include a warning light, an alarm, a video terminal, an operator console or any other device capable of alerting an operator.

According to another embodiment of the present invention, there is provided a wet hood having a system for electronically monitoring the wet hood operation. The wet hood includes a deck having a number of tanks and a detector shield mounted above the deck. The wet hood further includes an identification device and a number of infrared detectors, mounted on the detector shield, for monitoring the movement of the identification device from one tank to the next. The wet hood also includes a computer for receiving and storing signals from the infrared detectors and for providing an output signal to a warning light and an operator console to indicate the status of an operation. The computer also generates timers and stores predefined operation values. The computer may also provide a next-location signal to a warning light positioned on the deck by the next tank needed in the manual operation.

According to yet another embodiment of the present invention, there is provided a method for electronically monitoring an operation that includes establishing a detection zone for monitoring the entry and exit of an identification device. The method further includes detecting and identifying the entry and exit of the identification device and starting a timer in response. The method also includes comparing the timer value to a predefined process time value and signaling or alerting an operator when the timer value approaches the predefined process time value.

The present invention provides various technical advantages over manual operations or even fully automated operations that do not provide accurate historical operations data. For example, one technical advantage of the present invention includes the ability to objectively evaluate and train operators by comparing the desired process or operation times to actual operator times. Another technical advantage includes the ability to optimize manual operations by accessing historical operations data from a manual operation. Yet another technical advantage includes the ability to take corrective action to possibly recover from operator errors by detecting exactly which errors were made so that the proper corrective action may be taken. This may prevent having to discard items improperly processed. Other technical advantages are readily apparent to one skilled in the art from the following, description, and the accompanying figures.

### BRIEF DESCRIPTION OF THE DRAWINGS

For a more complete understanding of the present invention and the advantages thereof, reference is now made to the following description taken in conjunction with the accompanying drawings, wherein like reference numerals represent like parts, in which:
FIGURE 1 is a top view of a wet hood illustrating a system for electronically monitoring a wet hood operation for use in accordance with the present invention;
FIGURE 2 is a side cutaway view illustrating the system for electronically monitoring the wet hood operation in accordance with the present invention;
FIGURE 3 is an isometric view of a wafer boat for use in the wet hood operation; and
FIGURE 4 is a block diagram of a microcomputer for use in the system and method for electronically monitoring the wet hood operation in accordance with the present invention.

### DETAILED DESCRIPTION OF THE INVENTION

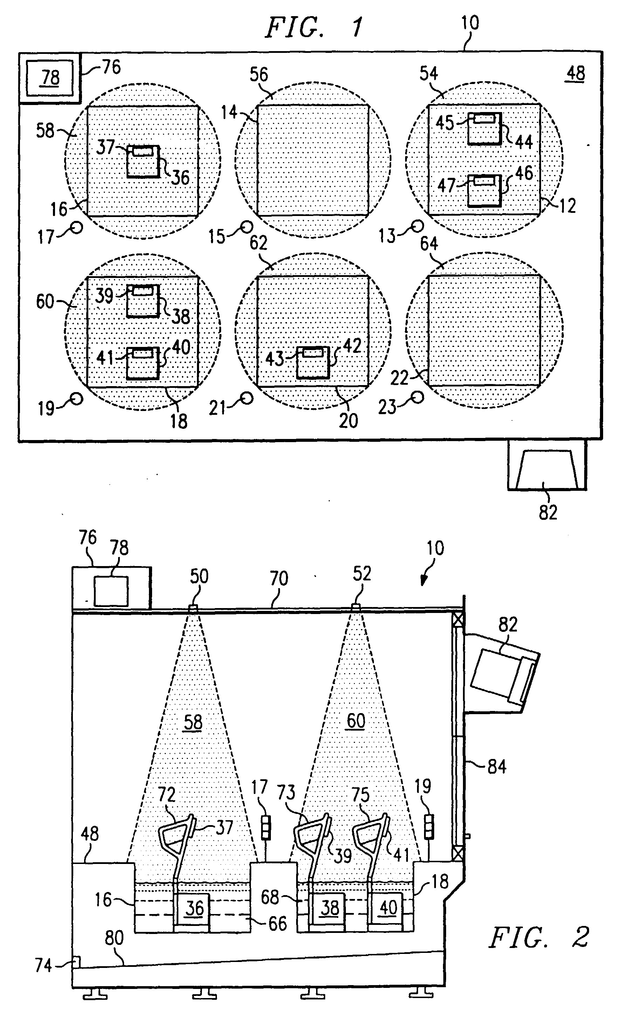

FIGURE 1 illustrates one embodiment of the present invention, a system for electronically monitoring the operation of wet hood 10. Wet hood 10 is used for various wet chemistry processes for operations such as semiconductor fabrication. Wet hood 10 includes six tanks mounted in a deck 48. A first tank 12, a second tank 14, a third tank 16, a fourth tank 18, a fifth tank 20, and a sixth tank 22 are all mounted in deck 48 of wet hood 10. Each tank is generally rectangularly shaped and contain any number of different chemicals used in a multitude of different processes or operations. For example, in semiconductor fabrication, the tanks of wet hood 10 may be used for semiconductor wet processing such as semiconductor wafer etching and cleaning. In such an application, these tanks may contain various chemicals including phosphoric acid, HF acid, nitric acid, hydrogen peroxide, and deionized water. The material or item being processed is placed in each of these tanks for a predefined period of time. After the predefined period of time, the material is manually moved by an operator to the next tank in the process or operation.

Each of the tanks of FIGURE 1 are monitored by an infrared detector that monitors when particular items or carriers enter and exit a tank. A circular detection zone, generated by each detector, is shown around each of the tanks of FIGURE 1 (dashed line). Each detector, not shown in FIGURE 1, is mounted above wet hood 10 and is positioned above a corresponding tank it is monitoring. Each detector produces the desired detection zone around a corresponding tank. These detectors sense when particular items, carriers or identification devices enter and exit the detection zone around a corresponding tank. The detectors generate a signal in response to an item entering and exiting a corresponding tank. A first detection zone 54, a second detection zone 56, a third detection zone 58, a fourth detection zone 60, a fifth detection zone 62, and a sixth detection zone 64 surround first tank 12, second tank 14, third tank 16, fourth tank 18, fifth tank 20, and sixth tank 22, respectively, these detection zones are generated by infrared detectors positioned above each tank. The geometry of the detection zones can be modified depending on the desired geometry and detector. As soon as one of the detection zones is violated or entered, the corresponding detector sends an entry signal to a computer/controller 78. Computer/controller 78 is mounted in an electrical enclosure 76 above wet hood 10 to protect the electronics from the hostile and potentially corrosive environment of wet hood 10.

The detectors illustrated in the one embodiment of the present invention shown in FIGURES 1-4 are infrared detectors. However, the present invention is not limited to infrared detectors and may in fact be any type of detector including an infrared detector, radio frequency detector, a TIRIS (Texas Instruments Registration and Identification System), or any other type of detecting technique. An example of one type of detecting technique that may be used in the present invention involves an identification device or tag coupled to the object whose movement is being monitored by an infrared detector. The identification device or identification tag emits a unique signal or beacon that may be detected by the infrared detector when it crosses that detectors detection zone.

First tank 12 is shown with a first boat 44, having first identification tag 45, and a second boat 46, having second identification tag 47, submerged therein for processing. First boat 44 and second boat 46 may be any carrier or device for holding an item or items for processing. When either first boat 44 or second boat 46 enter first detection zone 54 of first tank 12, an entry signal is sent to computer/controller 78 identifying that first boat 44 and second boat 46 entered first tank 12. First identification tag 45 and second identification tag 47 are detected when they enter first detection zone 54.

Similarly, a third boat 36, having a third identification tag 37, is shown submerged within third tank 16; a fourth boat 38, having a fourth identification tag 39, and a fifth boat 40, having a fifth identification tag 41, are shown submerged within fourth tank 18. A sixth boat 42, having a sixth identification tag 43, is shown submerged within fifth tank 20. Each of these tanks are surrounded by a corresponding detection zone. Third detection zone 58, fourth detection zone 60, and fifth detection zone 62 monitor these tanks. Second tank 14 and sixth tank 22 are shown in FIGURE 1 without a submerged boat. Second tank 14 is monitored by second detection zone 56 while sixth tank 22 is monitored by sixth detection zone 64.

As discussed above for first boat 44 and second boat 46, whenever these boats enter a detection zone surrounding a tank, a signal is sent to computer/controller 78 identifying when each boat entered the detection zone corresponding to its tank. Whenever any of the boats are removed from their tank, the surrounding detection zone is interrupted or broken which sends a signal to computer/controller 78 identifying which boat was removed from which tank and when.

A warning light is mounted in front and to the left of each of the tanks of FIGURE 1. A first warning light 13, a second warning light 15, a third warning light 17, a fourth warning light 19, a fifth warning light 21, and a sixth warning light 23 are mounted on deck 48 near their corresponding tank. These lights are controlled by computer/controller 78 and may display a variety of colors depending on the state of the operation. Whenever a boat enters a detection zone, an entry signal is sent to computer/controller 78. In response, computer/controller 78 sends a signal to the corresponding warning light to indicate that the particular process or procedure has begun in that tank. For example, when first boat 44, having first identification tag 45, enters first tank 12, it goes through first detection zone 54. In response, a signal is sent to computer/controller 78 which then starts an internal timer within computer/controller 78. Computer/controller 78 also sends a signal to first warning light 13. First warning light 13 responds by displaying a green light while first boat 44 is submerged within first tank 12. After a pre-defined period of time, computer/controller 78 sends another signal to first warning light 13 indicating that the time period that first boat 44 should stay submerged within first tank 12 is about to expire. First warning light 13 then displays a yellow light indicating to wet hood 10 operator that the time period is about to expire.

Once the full time period has expired, computer/controller 78 sends another signal to first warning light 13 directing it to display a red light indicating to the operator of wet hood 10 that the time period has expired and thus first boat 44 should be removed or should have been removed from first tank 12. When first boat 44 is actually removed from first tank 12, a signal is sent to computer/controller 78 so that the actual time first boat 44 was submerged within first tank 12 may be calculated and stored for historical analysis.

Operator console 82 is shown in FIGURE 1 and may be any number of available video terminals. Operator console 82 is for displaying countdown timers and for emitting audible alarms. Operator console 82 receives a signal from computer/controller 78, just as first warning light 13, second warning light 15, third warning light 17, fourth warning light 19, fifth warning light 21, and sixth warning light 23 receive a signal from computer/controller 78. Operator console 82, in response, may then present such information as status timers indicating the length of time a particular process or procedure has been occurring. Operator console 82 may also emit audible alarms indicating to an operator that a certain action needs to be taken in wet hood 10.

In operation, first tank 12, second tank 14, third tank 16, fourth tank 18, fifth tank 20, and sixth tank 22 are filled with a solution for use in a particular process. A carrier or boat is first placed in the desired tank for processing. For example, first boat 44, having first identification tag 45 is manually placed in first tank 12. As first boat 44 is placed within first tank 12, the detector, creating first detection zone 54, detects the presence of first identification tag 45. The detector in turn sends a signal to computer/controller 78 indicating that first identification tag 45 of first boat 44 has entered first tank 12. Computer/controller 78 in turn starts an internal timer tracking the length of time that first boat 44 remains within the solution of first tank 12. Computer/controller 78 correspondingly sends a signal to first warning light 13 indicating that a timer has started. Furthermore, computer/controller 78 may send a signal to operator console 82 initiating a visual timer on the screen of operator console 82. Operator console 82 may be any type of available video terminal that may display various status timers and graphics.

Computer/controller 78 compares the time that first boat 44 remains within first tank 12 to a period of time. As the timer approaches this period of time, computer/controller 78 may send an additional signal to first warning light 13 initiating a change in color of first warning light 13. This change in color of first warning light 13 should remind or indicate to the operator that the time period first boat 44 should remain within first tank 12 is nearing an end. Additionally, as the time period approaches, computer/controller 78 may send a signal to operator console 82 initiating an audible alarm at a particular frequency or flashing the screen of operator console 82, all in an effort to alert an operator that the time for a particular procedure or process is about to expire.

With all these reminders and indicators, an operator should be reminded to remove first boat 44 from first tank 12 to end that particular process or procedure. First boat 44 is now ready to be moved to the next tank for further processing. In some operations and procedures, first boat 44 may simply be moved to second tank 14, but this is not always the case. The embodiment of the present invention shown in FIGURE 1 has several ways in which an operator can be reminded of the next tank in which first boat 44 should be submerged. For example, first warning light 13, second warning light 15, third warning light 17, fourth warning light 19, fifth warning light 21, and sixth warning light 23 may have a separate light mounted for this particular purpose or may include a certain flashing pattern that indicates that this is the next tank in the process. Additionally, operator console 82 may graphically indicate which tank is next in the process or an audio alarm may be emitted to indicate the same. As also shown in FIGURE 1, two boats may be processed within one tank at the same time. For example, first boat 44 and second boat 46 are shown submerged within first tank 12.

FIGURE 2 is a side view illustrating wet hood 10 and the system for electronically monitoring the operation of wet hood 10. FIGURE 2 illustrates the placement of third boat 36 in third tank 16 and the placement of fourth boat 38 and fifth boat 40 within fourth tank 18. As shown, each of these boats has a corresponding handle and identification tag. Third boat 36 includes third identification tag 37 mounted to a third boat handle 72, fourth boat 38 includes fourth identification tag 39 coupled to a fourth boat handle 73, and fifth boat 40 includes fifth identification tag 41 coupled to a fifth boat handle 75. Third boat handle 72, fourth boat handle 73, and fifth boat handle 75 are used by operators to insert and remove the boats from the tanks. Third tank 16 is shown filled with a third tank solution 66, and fourth tank 18 is shown filled with a fourth tank solution 68. As discussed previously, the particular tank solution depends upon the process being performed.

Electrical enclosure 76, used for enclosing computer/controller 78, is shown mounted above detector shield 70. Detector shield 70 may be a piece of plexiglass or any similar type material. A third infrared detector 50 and a fourth infrared detector 52 are shown mounted on detector shield 70 and above their corresponding third tank 16 and fourth tank 18, respectively. Third infrared detector 50 produces third detection zone 58 above third tank 16, while fourth infrared detector 52 is mounted above fourth tank 18 and produces fourth detection zone 60. Third warning light 17 and fourth warning light 19 are used as output devices to indicate the status of third tank 16 and fourth tank 18, respectively. Main drain 74 of wet hood 10 is shown as an outlet for angled floor 80.

In operation, an operator approaches wet hood 10 from the right side of FIGURE 2. Sliding safety shield 84 is lifted to expose the internal volume of wet hood 10. Boats are then placed in the desired tanks for processing. For example, fifth boat 40 is shown within fourth tank solution 58 of fourth tank 18. As soon as detector 52 detects that fifth identification tag 41 mounted on fifth boat handle 75 has entered fourth detection zone 60, a signal is sent to computer/controller 78. Computer/controller 78 starts an internal timer in response to receiving this signal from fourth infrared detector 52. Computer/controller 78 sends a signal to fourth warning light 19 to display a green light. Computer/controller 78 also sends a signal to operation console 82 having it display either a countdown or count up timer.

As soon as the predefined, preprogrammed processing time for fifth boat 40 to remain submerged within fourth tank solution 68 approaches, a signal may be sent to fourth warning light 19 indicating that the time period is about to expire. Fourth warning light 19 will display an appropriate colored light in response. Operator console 82 may also receive a signal causing the timer display to blink or emit an audible alarm. After the predefined processing period has expired, computer/controller 78 will send a signal to fourth warning light 19 causing it to emit a red light indicating that the process time has expired. Operator console 82 may take some action in response such as sounding an alarm. An operator will manually remove fifth boat 40 from fourth tank 18 and move it to the next processing tank.

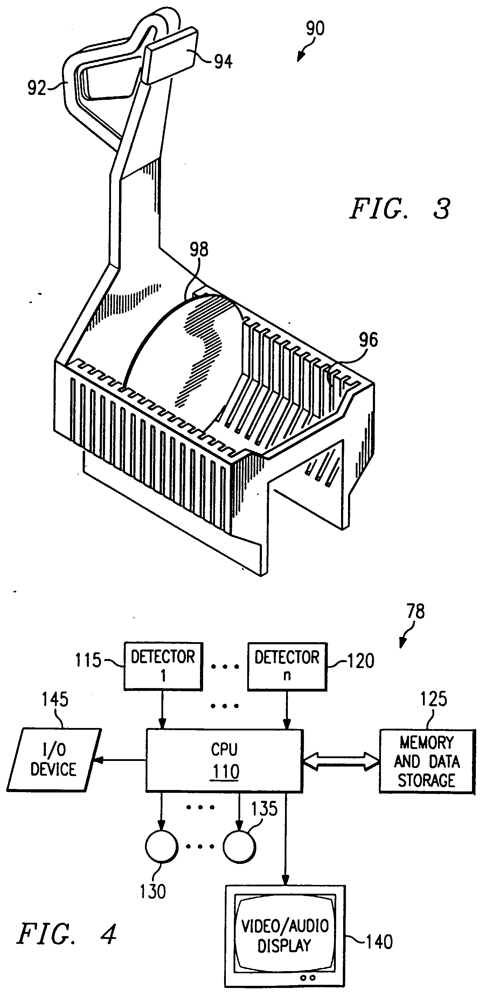

FIGURE 3 illustrates an isometric view of a wafer boat 90 which is similar to first boat 44, second boat 46, third boat 36, fourth boat 38, and fifth boat 40, detailed in FIGURES 1 and 2. Wafer boat 90 includes a handle 92 for inserting and removing wafer boat 90 into and from the various tanks. An identification tag 94 is attached to handle 92 of wafer boat 90. Identification tag 94 may be mounted in different locations on handle 92. For example, identification tag 94 may be mounted such that it is covered by an operator's hand that is grasping handle 92. The advantage of this arrangement is that identification tag 94 is not detected until an operator removes his hand from identification tag 94. This insures that the internal timing maintained by computer/controller 78 is not started until wafer boat 90 is firmly inserted into its tank. Otherwise, the internal timer may begin as soon as the detection zone is entered even though wafer boat 90 has not been fully immersed in the solution of its tank.

Wafer boat 90 in FIGURE 3 is used to carry semiconductor wafers that may require being submerged in various chemical solutions for processing. Wafer boat 90 is shown with a semiconductor wafer 98 positioned within a boat cargo bay 96. As shown, additional semiconductor wafers may be placed within boat cargo bay 96 for processing.

FIGURE 4 is a block diagram illustrating the operation of computer/controller 78. Computer/controller 78 may be represented by a central processing unit (CPU) 110 having inputs including first infrared detector block 115 through nth infrared detector block 120. These detectors send signals to CPU 110 indicating which boat has entered or exited a particular detection zone. Memory and data storage device 125 may send and receive information to/from CPU 110. First warning light block 130 and nth warning light block 135 are shown as outputs of CPU 110. CPU 110 controls these warning lights in response to receiving signals from the corresponding detector monitoring the tank corresponding to the warning light. An input/output device 145 is used to input data to CPU 110 which then may store it in memory and data storage device 125. Input/output device 145 may also receive data and output reports from CPU 110 to record historical data. Audio and video display device 140 is similar to operator console 82 shown in FIGURES 1 and 2. Input/output device 145 receives signals from CPU 110 so that audio and video display device 140 may display such things as countdown and count up timers, text messages, and emit audio alarms.

In operation, input/output device 145 sends data to CPU 110 corresponding to the length of time of various processes and procedures. This information is stored in memory and data storage device 125. Next, first infrared detector block 115 through nth infrared detector block 120 provide input to CPU 110 indicating when particular boats or carriers enter or exit a particular detection zone. In response, CPU 110 starts an internal timer. This internal timer is then correlated to the required time for a particular process or procedure that was previously provided from input/output device 145. CPU 110 also sends a signal to the warning light corresponding to the detector which provided a signal to CPU 110. For example, first infrared detector block 115 may correspond to first warning light block 130, thus when first infrared detector block 115 supplies a signal to CPU 110, CPU 110 then sends a signal to first warning light block 130 indicating that the process or procedure has begun.

CPU 110 compares the time that a process begins to the required time provided initially by input/output device 145. As the actual time approaches the required time, CPU 110 may send a signal to the corresponding warning light indicating that the required time is fast approaching. CPU 110 may also send such a warning signal to audio and video display device 140, requesting it to take appropriate action. CPU 110 continues to compare the actual time to the required time and once the actual time surpasses the required time, CPU 110 may send out another signal to the corresponding warning light and to audio and video display device 140.

CPU 110 stores the actual time of a process in memory and data storage device 125 so that historical reports may be later produced indicating the actual time each boat or carrier spent within a tank for a particular process. Input and output device 145 may be a combination terminal and printer for providing both input and output information.

Though computer/controller 78 is illustrated in FIGURE 4 by functional blocks, computer/controller 78 may actually be any common variety microcomputer having RAM memory and hard disk storage. Computer/controller 78 has the ability to set and reset internal timers and store actual data so that actual data may be later compared to required or desired data in a variance report. Memory and data storage device 125 may be the combination of a hard disk drive and RAM. First warning light block 130 through nth warning light block 135 may be any type of light, preferable one capable of producing light of different colors. Audio and video display device 140 may be any type of video terminal capable of providing any video and audio output.

In summary, many of the existing structures and installations used for various operations and processes may not be easily modified and converted to provide fully automated operations. The present invention provides an alternative to full automation by providing an approach that provides many of the advantages of a fully automated system. For example, operators may be objectively evaluated by comparing the desired process or operation times to actual times. Various operations and processes may be further optimized by evaluating historical data and comparing actual data to actual results obtained. Furthermore, when human errors are made, the present invention provides the ability to detect exactly which errors were made so that corrective action may be taken to possibly prevent having to discard items improperly processed.

Thus, it is apparent that there has been provided, in accordance with the present invention, a system and method for electronically monitoring an operation that satisfy the advantages set forth above. Although the preferred embodiment of the present invention has been described in detail, it should be understood that various changes, substitutions, and alterations can be made herein. For example, the preferred embodiment illustrates the monitoring of a wet hood process. However, the present invention need not be limited to merely monitoring a wet hood process but could be applied to any similar situation while still achieving the desired results demonstrated by the present invention. Other examples are readily ascertainable by one skilled in the art and could be made without departing from the spirit and scope of the present invention.

## Claims

1. A system for monitoring an operation or process, the system comprising:
an identification device having a unique identification number that may be monitored and identified;
a plurality of detectors each operable to monitor a particular detection zone and operable to identify and detect the entry and exit of identification devices into and out of each detection zone each detector further being operable to provide an entry data signal after identifying and detecting the entry of the identification device into a detection zone;
a computer operable to receive and store the entry data signal from the detector when the identification device enters the detection zone of one of the detectors, the computer further being operable to provide a first output signal in response thereof; and
an output device operable to receive the first output signal and generate an output response therefrom.

2. The system of Claim 1, wherein the output device is an operator console operable to generate an audio and video output in response to receiving the first output signal from the computer.

3. The system of Claim 1, wherein the output device is a warning light operable to generate a first light in response to receiving the first output signal from the computer.

4. The system of Claim 3 further comprising a plurality of warning lights each corresponding to one of the plurality of detectors, each warning light operable to generate a first light in response to receiving the first output signal from the computer, the computer further being operable to provide the first output signal to a corresponding warning light associated with a detector providing the entry data signal.

5. The system of any preceding claim, wherein the computer is further operable to start a timer in response to receiving the entry data signal from the detector and comparing the value of the timer to a predefined value.

6. The system of Claim 5 wherein each detector is further operable to provide an exit data signal after identifying and detecting the exit of the identification device, the computer further being operable to receive the exit data signal and to reset the timer in response thereof and to provide a next-location signal, the output device further operable to receive the next-location signal and to indicate the next location for the identification device.

7. The system of Claim 5 or Claim 6, wherein the computer is further operable to provide a second output signal when the value of the timer approaches the predefined value, and wherein the warning light is further operable to receive the second output signal and to generate a second light in response to receiving the second output signal.

8. The system of Claim 7 wherein the warning light generates a flashing light in response to receiving the second output signal from the computer.

9. The system of Claim 7 or Claim 8, wherein the computer provides a third output signal when the timer value equals or exceeds the predefined value, and wherein the warning light is further operable to receive the third output signal and to generate a third light in response to receiving the third output signal.

10. The system of any of Claims 2, 5 & 6, wherein the output device is an operator console is operable to generate a first video output in response to receiving the first output signal from the computer, and wherein the computer is further operable to provide a second output signal when the value of the timer approaches the predefined value, and wherein the operator console is further operable to receive the second output signal and to generate a second video output in response to receiving the second output signal.

11. The system of Claim 10 wherein the computer provides a third output signal when the timer value equals or exceeds the predefined value, and wherein the operator console is further operable to receive the third output signal and to generate a third video output in response to receiving the third output signal.

12. The system of Claim 11 wherein the first video output, the second video output, and the third video output include an audio output.

13. The system of any of Claims 2 to 12, wherein the operator console generates and displays a timer in response to receiving the first output signal from the computer.

14. The system of any preceding claim, wherein the plurality of detectors are infrared detectors.

15. A wet hood having a system for monitoring the wet hood operation, the wet hood comprising:
a deck having a plurality of tanks;
a detector shield mounted above the deck; and
a system for monitoring the operation of the wet hood, the system including:
an identification device having a unique identification number that may be monitored and identified;
a plurality of detectors, each detector mounted on the detector shield and positioned above a corresponding tank, each detector operable to monitor a particular detection zone above and around its corresponding tank, each detector further operable to identify and detect the entry and exit of the identification device into and out of the detection zone and to provide an entry data signal and exit data signal in response;
a computer operable to receive and store the entry data signal and the exit data signal from each detector, the computer further operable to provide an entry output signal and an exit output signal in response;
an operator console operable to receive the entry output signal and further operable to generate a first video output in response; and
a warning light operable to receive the entry output signal and further operable to generate a first light in response.

16. The wet hood of Claim 15 wherein the computer is further operable to start a timer in response to receiving the entry data signal from any of the detectors and comparing the value of this timer to a predefined value.

17. The wet hood of Claim 16 wherein the computer is further operable to receive the exit data signal and to reset the timer in response and to provide a next-location signal, the warning light is further operable to receive the next-location signal and to generate a second light in response, and the operator console is further operable to receive the next-location signal and to generate a second video in response.

18. The wet hood of any of Claims 15 to 17, wherein the detectors are infra-red detectors.

19. A method for monitoring an operation comprising the steps of:
establishing a detection zone for monitoring the entry and exit of an identification device;
detecting and identifying the entry of the identification device into the detection zone;
starting a timer in response to detecting and identifying the entry of the identification device;
comparing the timer value to a predefined value; and
alerting an operator when the timer value approaches the predefined value.

20. The method of Claim 19, further comprising the steps of:
alerting an operator if the timer value equals or exceeds the predefined value;
detecting the exit of the identification device from the detection zone and stopping the timer in response; and
storing the timer value.

21. The method of Claim 19 or Claim 20, further comprising the steps of:
alerting an operator of the next operation location in response to detecting the exit of the identification device from the detection zone.
